# EUROPEAN PATENT SPECIFICATION

(11) **EP 0 549 042 B1**
(45) Date of publication and mention of the grant of the patent: **12.03.1997**
(21) Application number: 92203924.3
(22) Date of filing: 15.12.1992
(51) Int. Cl.: H01L 29/772, H01L 29/41, H01L 29/06

(54) **Improved high voltage thin film transistor having a drift region with a linear doping profile and a field plate**
Hochspannung-Dünnfilmtransistor mit einer Drift-Zone mit einem linearen Dopierungsprofil und mit einer Feldplatte
Transistor à couche mince et à haute tension dont la région de drift possède un dopage linéaire et une plaque de champ

(30) Priority: 20.12.1991 US 811554
(43) Date of publication of application: 30.06.1993
(73) Proprietor: Philips Electronics N.V., 5621 BA Eindhoven (NL)
(72) Inventor: Merchant, Steven, NL-5656 AA Eindhoven (NL)
(74) Representative: Veerman, Jan Willem

(56) References cited:
- EP-A- 0 400 934
- EP-A- 0 497 427
- US-A- 3 845 495
- US-A- 4 172 260
- US-A- 4 333 225
- IEEE INTERNATIONAL SOLID-STATE CIRCUITS CONFERENCE vol. 19, no. 19, 1976, NEW YORK US pages 58 - 59 MICHAEL R. SPLINTER ET AL 'High Voltage SOS/MOS Devices and Circuit Elements'
- PROCEEDINGS OF THE 3RD INTERNATIONAL SYMPOSIUM ON POWER SEMICONDUCTOR DEVICES AND ICS ISPSD'91 STOUFFER HARBORPLACE HOTEL, BALTIMORE, MARYLAND, USA APRIL 22-24 pages 36 - 39 QIN LU ET AL 'HIGH VOLTAGE SILICON-ON-INSULATOR(SOI) MOSFETs'

## Description

The invention relates to a thin film SOI device, comprising a buried oxide layer, a thin layer of silicon on said buried oxide layer having a drift region, a top oxide layer on said thin layer of silicon, a gate region at the one end of said drift region said gate region including a gate electrode and a field plate extending from said gate electrode over said drift region, a drain region at the opposite end of said drift region and a source region laterally separated from said gate region.

Such a device is known from US Patent No. 3,845,495.

The present invention seeks to improve the breakdown voltages of the known device.

Therefore the device is characterized in that the doping level in the drift region in the thin layer increases in a lateral direction a substantially linear and continuous way from the one end of the drift region to the opposite end of the drift region, where said buried oxide layer and said top oxide layer have substantially the same thickness. The gate electrode is formed at one side of the drift region which is covered by an upper oxide layer. Accordingly, the gate electrode extends from the gate region laterally over the top of this oxide layer to cover all of the underlying drift region of the silicon layer.

In the inventive device a well protected drift region is provided since any impinging electric field, caused by moisture or other charged contaminants on the surface of the wafer, will terminate on the field plate of the gate electrode overlying the drift region. Further because of the buried and top oxide layer having the same thickness, the drift region may now be depleted from both the top and bottom, so that twice the conducting charge may be placed on the drift region to lower the on-resistance.

It is further known from EP application 497427 which was published after the priority date of the present application to provide a thin film SOI device with a lateral linear doping drift region, i.e. a drift region which has a certain dope level at one side of the drift region, which dope level changes in a linear way in a lateral direction of the drift region from a relatively low level near the gate region to a relatively high level near the drain region. In this known device the silicon layer is provided as a thin layer of silicon having a thickness of about 200 to 300 nanometres. This structure forms a SOI semiconductor device having a high breakdown voltage characteristic.

It is further known from US Patent No. 4,172,260 to use a drift region with a graded doping profil to increase breakdown voltages.

The method of manufacturing this improved structure comprises forming a silicon layer on a buried oxide layer with the buried oxide layer being formed on a semiconductor substrate, forming a lateral linear doping region in the silicon layer, selectively thinning the drift region by local oxidation (LOCOS), leaving a thick top oxide layer over the drift region, and forming a gate region at a side of the top oxide layer with the gate region having a gate electrode with a portion extending laterally over a substantial portion of the top oxide layer where the lateral extent of the gate electrode overlies the thin lateral linear doping region. This technique of the present invention achieves the high voltage SOI semiconductor device having the improvements of the present invention.

The invention will be described in detail, by way of example, with reference to the drawing figures. Therein:
Figure 1 illustrates in cross-section the improved thin film transistor according to the present invention; and
Figure 2 illustrates a simulated computer plot of potential contours in a device having a lateral gate extension according to the present invention. Similar reference numbers are used to identify corresponding parts of respective drawings.

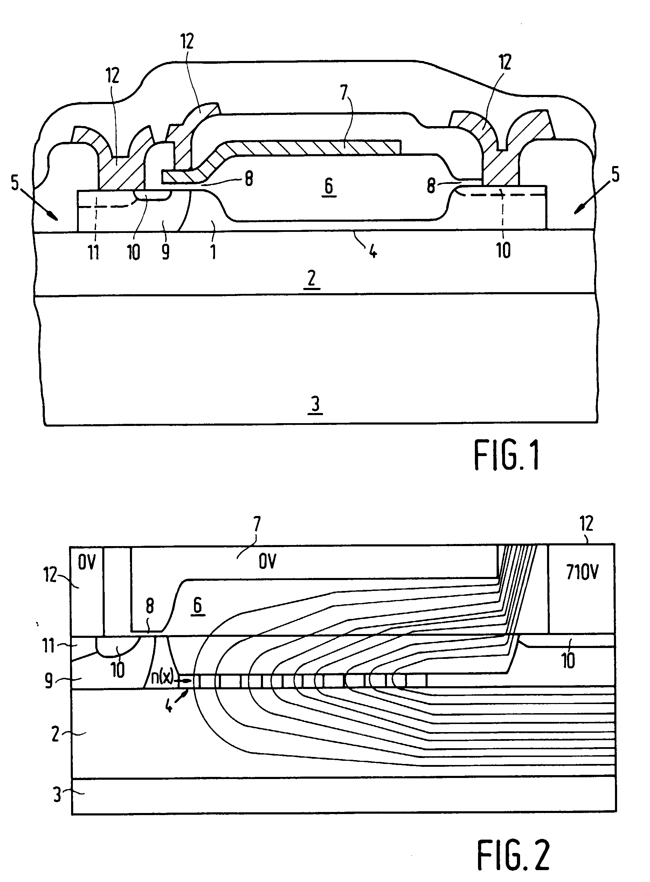

The improved SOI transistor of the present invention is illustrated in Figure 1. Therein, a substrate 3 which may be either n-type or p-type conductivity of any resistivity is provided. An oxide layer 2 is deposited onto this substrate layer. The thickness of the oxide layer 2 ranges from about 1 to 1.5 microns. Onto the oxide layer 2 is formed a silicon layer 1 having a linear lateral doping region 4. The formation of this linear lateral doping region is similar to that in EP application 497427. This way an SOI structure is formed, with the oxide layer 2 now forming the buried oxide layer 2. The area of the SOI device is surrounded by isolation regions 5 of insulating material. The silicon layer 1 is selectively thinned to a thickness ranging from 100 to 200 nanometres by standard LOCOS techniques. This involves using a mask of silicon nitride around the region 4 and growing a 1 to 1.5 micron thick layer of thermal silicon dioxide 6. This leaves the thinned layer 4 with the lateral linear doping profile providing the drift region of the SOI device.

A polysilicon gate electrode and field plate 7 is formed by first growing a thin gate oxide 8 having a thickness of approximately 60 nanometer at the side of the oxide 6. Thereafter, 500 nanometres of polysilicon are deposited thereon to form the gate electrode and field plate region. In accordance with the present invention, a mask is provided before forming the gate electrode 7 to expose the upper surface of the silicon dioxide layer 6 so that the gate electrode 7 extends onto the surface of the upper oxide layer 6 as the field plate region.

This field plate extends from the gate electrode over the drift region portion of the thinned silicon layer 4.
The source and drain regions 10 are then formed of N+ conductivity, for example, at the sides of the gate and drift region. A p+ source region 11 is also formed so that the source contact 12 contacts both regions. A drain contact 12 is formed in contact with the drain region 10, while a gate contact 12 is formed in contact with the gate region 7 overlying the thin oxide layer 8. The top oxide layer 6 is formed with a thickness equal to the buried oxide layer 2. Also, the field plate of the gate electrode 7 extends laterally over the drift region 4.

A well protected drift region 4 is provided since any impinging external field, caused by moisture or other charged containments on the surface of the wafer, will terminate on the field plate of the gate electrode overlying the drift region. Further, the drift region may now be depleted from both the top and bottom so that twice the conducting charge may be placed on the drift region to lower the on-resistance. In addition, since the SOI film is thick (0.75 - 1.25 microns) in the source and drain regions, the p-body 9 is not left floating as in the known device.

Figure 2 shows a simulated computer plot of the electrostatic potential contours in a typical device having the field plate and gate 7 of the present invention. Such a SOI device has a high breakdown voltage of approximately 710 volts. The optimized drift region has a lateral doping profile n(x) with a peak doping near the drain region which is twice that of an identical structure without the gate electrode and field plate 7. The minimum drift region doping of the drift region 4, i.e. toward the gate structure, is also increased by a factor of 2.

## Claims

1. A thin film SOI device, comprising a buried oxide layer (2), a thin layer of silicon (1) on said buried oxide layer (2) having a drift region (4), a top oxide layer (6) on said thin layer of silicon (1), a gate region at the one end of said drift region (4) said gate region including a gate electrode (7) and a field plate (7) extending from said gate electrode (7) over said drift region (4), a drain region (10) at the opposite end of said drift region (4) and a source region (10) laterally separated from said gate region, characterised in that the doping level in the drift region (4) in the thin layer (1) increases in a lateral direction in a substantially linear and continuous way from the one end of the drift region (4) to the opposite end of the drift region (4), where said buried oxide layer (2) and said top oxide layer (6) have substantially the same thickness.

2. A thin film SOI device as claimed in Claim 1, wherein said buried oxide layer (2) and said top oxide layer (6) each have a thickness ranging from about 1 to 1.5 microns.

3. A thin film SOI device as claimed in Claim 1, wherein said layer of silicon (1) has a thickness ranging from 100 to 200 nanometres.

4. A thin film SOI device as claimed in Claim 1, wherein said gate electrode (7) and said field plate (7) each have a thickness of 500 nanometres.

5. A method of making a semiconductor device according to any of the preceding claims, comprising the steps of
(a) forming a silicon layer (1) on a buried oxide layer (2), said buried oxide layer (2) being formed on a semiconductor substrate (3),
(b) forming a drift region (4) in said silicon layer (1),
(c) simultaneously thinning said drift region (4) to a reduced thickness, and depositing a top oxide layer (6) over the thinned drift region (4), and
(d) forming a gate region at a side of said top oxide layer (6), characterized in that the drift region is formed with a doping level that increases in a substantially linear way in a lateral direction from one end of the drift region (4) to the opposite end of the drift region, where said gate region has a gate electrode with a field plate (7) extending laterally over a substantial portion of said top oxide layer (6), the lateral extent of said field plate (7) overlying said drift region (4).

6. A method according to Claim 5, characterised in that said buried oxide layer (2) and said top oxide layer (6) are formed with equal thickness.

7. A method according to Claim 5, characterised in that said buried oxide layer (2) and said top oxide layer (6) are each formed with a thickness of about 1 to 1.5 micrometers.

8. A method according to Claim 5, characterised in that said lateral linear doping region (4) is thinned to a thickness ranging from about 100 to 200 nanometres.

9. A method according to Claim 5, characterised in that said silicon layer (1) from step (a) is formed to a thickness of about 0.75 to 1.25 micrometers.

## Patentansprüche

1. Dünnschicht-SOI-Anordnung mit einer vergrabenen Oxidschicht (2), einer dünnen Siliziumschicht (1) auf der vergrabenen Oxidschicht (2) mit einer Drift-Zone (4), einer oberen Oxidschicht (6) auf der dünnen Silizium-Schicht (1), einer Gate-Zone am einen Ende der Drift-Zone (4), wobei die Gate-Zone eine Steuerelektrode (7) und eine Feldplatte (7), die sich von der Steuerelektrode (7) über die Drift-Zone (4) erstreckt, eine Drain-Zone (10) am gegenüberliegenden Ende der Drift-Zone (4) und eine seitlich von der Gate-Zone getrennte Source-Zone (10) enthält, dadurch gekennzeichnet, daß der Dotierungspegel in der Drift-Zone (4) in der dünnen Schicht (1) in seitlicher Richtung auf eine im wesentlichen linearen und ununterbrochenen Weise vom einen Ende der Drift-Zone zum gegenüberliegenden Ende der Drift-Zone (4) höher wird, wobei die vergrabene Oxidschicht (2) und die obere Oxidschicht (6) im wesentlichen die gleiche Dicke haben.

2. Dünnschicht-SOI-Anordnung nach Anspruch 1, worin die vergrabene Oxidschicht (2) und die obere Oxidschicht (6) je eine Dicke im Bereich von 1 bis 5 µ haben.

3. Dünnschicht-SOI-Anordnung nach Anspruch 1, worin die Silizium-Schicht (1) eine Dicke im Bereich von 100 bis 200 nm besitzt.

4. Dünnschicht-SOI-Anordnung nach Anspruch 1, worin die Steuerelektrode (7) und die Feldplatte (7) je eine Dicke von 100 bis 200 nm besitzen.

5. Verfahren zum Herstellen einer Haalbleiteranordnung nach einem oder mehreren der vorangehenden Ansprüche, mit den Schritten
a. zum Anbringen einer Silizium-Schicht (1) auf einer vergrabenen Oxidschicht (2), wobei die vergrabene Oxidschicht (2) auf einem Halbleitersubstrat erzeugt wird,
b. zum Erzeugen einer Drift-Zone in der Silizium-Schicht (1),
c. zum gleichzeitigen Abdünnen der Drift-Zone (4) auf eine reduzierte Dicke, und zum Ablagern einer oberen Oxidschicht (6) auf der abgedünnten Drift-Zone (4), und
d. zum Erzeugen einer Gate-Zone an einer Seite der oberen Oxidschicht (6), dadurch gekennzeichnet, daß die Drift-Zone mit einem Dotierungspegel erzeugt ist, der auf eine im wesentlichen lineare Weise in einer seitlichen Richtung von einem Ende der Drift-Zone (4) zum gegenüberliegenden Ende der Drift-Zone h_her wird, wobei die Gate-Zone eine Steuerelektrode mit einer Feldplatte (7) enthält, die sich seitlich über einen wesentlichen Teil der oberen Oxidschicht (6) erstreckt, wobei die seitliche Verlängerung der Feldplatte (7) sich über die Drift-Zone 4) erstreckt.

6. Verfahren nach Anspruch 5, dadurch gekennzeichnet, daß die vergrabene Oxidschicht (2) und die obere Oxidschicht (6) mit gleicher Dicke erzeugt werden.

7. Verfahren nach Anspruch 5, dadurch gekennzeichnet, daß die vergrabene Oxidschicht (2) und die obere Oxidschicht (6) mit je einer Dicke von etwa 1 bis 1,5 µ erzeugt werden.

8. Verfahren nach Anspruch 5, dadurch gekennzeichnet, daß die seitliche Lineardotierungs-Zone (4) auf eine Dicke im Bereich von etwa 100 bis 200 nm abgedünnt ist.

9. Verfahren nach Anspruch 5, dadurch gekennzeichnet, daß die Silizium-Schicht (1) in einem Schritt (a) mit einer Dicke zwischen etwa 0,75 und 1,25 µ erzeugt wird.

## Revendications

1. Dispositif SSI à couche mince, comprenant une couche d'oxyde enterrée (2), une mince couche de silicium (1) située sur la couche d'oxyde enterrée (2) avec une région de migration (4), une couche d'oxyde supérieure (6) située sur la mince couche de silicium (1), une région de grille à une extrémité de la région de migration (4), la région de grille comprenant une électrode de grille (7) et une plaque de champ (7) qui s'étend depuis l'électrode de grille (7) au-dessus de la région de migration (4), une région de drain (10) à l'extrémité opposée de la région de migration (4) et une région de source (10) séparée latéralement de la région de grille, caractérisé en ce que le niveau de dopage dans la région de migration (4) dans la mince couche (1) augmente de manière continue et sensiblement linéaire dans une direction latérale de la première extrémité de la région de migration (4) jusqu'à son extrémité opposée, où la couche d'oxyde enterrée (2) et la couche d'oxyde supérieure (6) ont sensiblement la même épaisseur.

2. Dispositif SSI à couche mince suivant la revendication 1, dans lequel la couche d'oxyde enterrée (2) et la couche d'oxyde supérieure (6) ont chacune une épaisseur comprise entre environ 1 et 1,5 micron.

3. Dispositif SSI à couche mince suivant la revendication 1, dans lequel la couche de silicium (1) a une épaisseur comprise entre 100 et 200 nanomètres.

4. Dispositif SSI à couche mince suivant la revendication 1, dans lequel l'électrode de grille (7) et la plaque de champ (7) ont chacune une épaisseur de 500 nanomètres.

5. Procédé de fabrication d'un dispositif à semi-conducteur suivant l'une quelconque des revendications précédentes, comprenant les étapes consistant à
(a) former une couche de silicium (1) sur une couche d'oxyde enterrée (2), la couche d'oxyde enterrée (2) étant formée sur un substrat à semi-conducteur (3),
(b) former une région de migration (4) dans la couche de silicium (1),
(c) simultanément, amincir la région de migration (4) jusqu'à une épaisseur réduite, et déposer une couche d'oxyde supérieure (6) sur la région de migration amincie (4), et
(d) former une région de grille d'un côté de la couche d'oxyde supérieure (6),
caractérisé en ce que la région de migration est formée avec un niveau de dopage qui augmente d'une manière sensiblement linéaire dans une direction latérale depuis une extrémité de la région de migration (4) jusqu'à l'extrémité opposée de la région de migration, où la région de migration a une électrode de grille avec une plaque de champ (7) qui s'étend latéralement sur une partie importante de la couche d'oxyde supérieure (6), l'étendue latérale de la plaque de champ (7) recouvrant la région de migration (4).

6. Procédé suivant la revendication 5, caractérisé en ce que la couche d'oxyde enterrée (2) et la couche d'oxyde supérieure (6) sont formées avec la même épaisseur.

7. Procédé suivant la revendication 5, caractérisé en ce que la couche d'oxyde enterrée (2) et la couche d'oxyde supérieure (6) sont chacune formées avec une épaisseur comprise entre environ 1 et 1,5 micromètre.

8. Procédé suivant la revendication 5, caractérisé en ce que la région (4) à dopage linéaire latéral est amincie jusqu'à une épaisseur comprise entre environ 100 et 200 nanomètres.

9. Procédé suivant la revendication 5, caractérisé en ce que la couche de silicium (1), provenant de l'étape (a), est formée à une épaisseur comprise entre environ 0,75 et 1,25 micromètre.
